# EUROPEAN PATENT SPECIFICATION

(11) **EP 2 198 434 B1**
(45) Date of publication and mention of the grant of the patent: **02.03.2011**
(21) Application number: 07821007.7
(22) Date of filing: 08.10.2007
(51) Int. Cl.: H01B 3/40, H01B 19/04, B32B 33/00

(54) **SURFACE MODIFIED ELECTRICAL INSULATION SYSTEM WITH IMPROVED TRACKING AND EROSION RESISTANCE**
OBERFLÄCHENMODIFIZIERTES ELEKTRISCHES ISOLATIONSSYSTEM MIT VERBESSERTEM TRACKING UND EROSIONSWIDERSTAND
SYSTÈME D'ISOLATION ÉLECTRIQUE À SURFACE MODIFIÉE, AYANT UNE RÉSISTANCE AU CHEMINEMENT ET À L'ÉROSION AMÉLIORÉE

(43) Date of publication of application: 23.06.2010
(73) Proprietor: ABB Research Ltd., 8050 Zürich (CH)
(72) Inventor: CLIFFORD, Stephen, CH-5620 Bremgarten (CH); SINGH, Bandeep, Wytheville Virginia 24382 (US); KRIVDA, Andrej, CH-5430 Wettingen (CH); SCHMIDT, Lars, CH-8048 Zürich (CH); GREUTER, Felix, CH-5406 Rütihof (CH); SCHMID, Veronika, CH-5400 Baden (CH)
(74) Representative: ABB Patent Attorneys
(86) International application number: PCT/EP2007/060634
(87) International publication number: WO 2009/046755

(56) References cited:
- WO-A-00/08659
- WO-A-2005/038071
- US-A- 5 718 967
- US-B1- 6 764 616
- FLESZYNSKI J ET AL: "BEHAVIOUR OF MODIFIED INSULATOR SURFACE MATERIAL UNDER ELECTRIC STRESS" NORDIC INSULATION SYMPOSIUM, XX, XX, 10 June 1996 (1996-06-10), pages 115-121, XP000870381

## Description

The present invention refers to a surface modified electrical insulation system with improved tracking and erosion resistance. The present invention especially refers to a surface modified electrical insulation system comprising a synthetic polymer composition including a filler and further additives, said synthetic polymer composition being coated with a thin coating composition that has a melting point which is distinctly higher than the melting point or degradation temperature of the polymer composition.

Outdoor electrical insulations often are exposed to surface discharges in-service. The temperature of surface discharges is generally higher than 1000°C (>1000°C). In the case of electrical insulation systems based on synthetic polymers filled with a filler composition, these high discharge temperatures lead to erosion and carbonization (also called tracking) of the insulation material since the degradation temperature of polymeric insulation material typically is much lower than 1000°C, and generally lower than 400°C (< 400°C). Epoxy resin compositions generally start to degrade at temperatures around 250°C.

### State of the art

In US 6,541,118 an electrical insulator with a molding made of ceramic and a hydrophobic coating applied to the surface of the molding is disclosed, the hydrophobic coating comprising a plasma polymer having been applied directly to the ceramic. Ceramic materials are very stable having a high dimensional stability and a great resistance to heat. It is therefore possible to coat the ceramic surfaces with a thin coating, for example a plasma polymer coating, having been applied directly to the ceramic surface.

Outdoor electrical insulations, especially for high-voltage applications, very often are based on synthetic polymers filled with a filler composition. Such preferred synthetic polymer compositions are for example epoxy resin compositions comprising fillers and further additives. These epoxy resin compositions are often based on cycloaliphatic epoxy resins, having a silica filler content within the range of 60 % to 80 %, and generally 65 %, by weight, calculated to the total weight of the insulation system. There is a need to increase the time during which such polymeric insulation can withstand exposure to the high temperatures of surface discharges without degradation. The resistance of such insulators to the high temperatures of surface discharges, without degradation is measured with the (International Electrotechnical Commission) IEC 60587 inclined plane tracking standard test.

### Description of the invention

It has now been found that an electrical insulation system made from a synthetic polymer composition, especially made from a cycloaliphatic epoxy resin composition comprising at least one filler and optionally further additives, can be coated with a thin coat of a thickness within the range of 50 nanometer (50 nm or 50 x 10⁻³ µm) to 50 µm (micron), said thin coat being an electrically non-conductive polymeric material and having a melting point which is distinctly higher than the melting point of the synthetic filler containing polymer composition, thereby increasing markedly the time during which such polymeric insulation system can withstand exposure to the high temperatures of surface discharges without degradation. Preferably said polymeric insulation system has a filler content within the range of 60 % to 80 % by weight calculated to the total weight of the insulation system. This effect is surprising since the surface of an electrical insulation system made from a synthetic polymer composition is permeable for components within the insulation system and numerous other properties such as the dimensional stability and resistance to heat are very much different from ceramic surfaces.

The present invention is defined in the claims. The present invention specifically refers a surface modified electrical insulation system comprising a hardened or cured synthetic polymer composition including at least one filler and optionally further additives, **characterized in that** the surface of said synthetic polymer composition is modified by being coated with a thin coating;
- said thin coating being applied by a plasma enhanced chemical vapor deposition (PECVD) with a thickness within the range of 50 nanometer to 50 µm; and/or
- said thin coating being applied by a by a sol-gel technique with a thickness within the range of 0.5 micron to 1 mm; and wherein
- said thin coat being an electrically non-conductive polymeric material having a melting point which is distinctly higher than the melting point or degradation temperature of the synthetic filler containing polymer composition.

According to the present invention it is also possible that both types of thin coatings being applied, either one on top of the other in any desired sequence.

The present invention further refers to a method of producing said surface modified electrical insulation system. The present invention further refers to the use of said surface modified electrical insulation system as an insulation system in electrical articles. The present invention further refers to the electrical articles comprising said surface modified electrical insulation system.

The surface modified electrical insulation system according to the present invention comprises a synthetic polymer composition. Said polymer may be selected from polymers known in the art of being used in electrical insulator composition, such as polyesters, for example poly(methyl-methacrylate), or poly(alkyl-acrylonitrile), or duroplastic polymers such as polyurethanes or epoxy resin compositions. Preferred are epoxy resin compositions, preferably cycloaliphatic epoxy resin compound. Said epoxy resin compositions generally contain a hardener, a curing agent to accelerate the curing process, as well as further additives. These compounds are known per se.

Cycloaliphatic epoxy resin compounds as used within the scope of the present invention contain at least two 1,2-epoxy groups per molecule. Cycloaliphatic epoxy resin compounds useful for the present invention comprise unsubstituted glycidyl groups and/or glycidyl groups substituted with methyl groups. These glycidyl compounds have an epoxy value (equiv./kg) preferably of at least three, preferably at least four and especially at five or higher, preferably 5.0 to 6.1. Preferred are for example optionally substituted epoxy resins of formula (I):

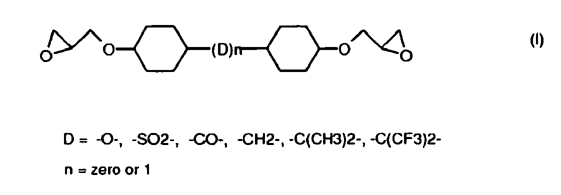

Compounds of formula (I) wherein D is -(CH₂)- or [-C(CH₃)₂-] are preferred. Further cycloaliphatic epoxy resins to be used within the scope of the present invention further are for example hexahydro-o-phthalic acid-bis-glycidyl ester, hexahydro-m-phthalic acid-bis-glycidyl ester or hexahydro-p-phthalic acid-bis-glycidyl ester. Preferred cycloaliphatic epoxy resin compounds are liquid at room temperature or when heated to a temperature of up to about 65°C. Preferred cycloaliphatic epoxy resin compounds are for example Araldite® CY 184 (Huntsman Advanced Materials Ltd.), a cycloaliphatic epoxy resin compound (diglycidylester) having an epoxy content of 5.80-6.10 (equiv/kg) or Araldite® CY 5622 (Huntsman Advanced Materials Ltd.), a modified epoxy resin compound (diglycidylester) having an epoxy content of 5.80-6.10 (equiv/kg). Araldite® CY 5622 is a hydrophobic cycloaliphatic epoxy formulation for hydrophobicity transfer and recovery in outdoor epoxy resin compositions. A hydrophobic cycloaliphatic epoxy formulation means that the filler material has been pretreated with a silane or a silane additive has been added to the composition.

The epoxy resin composition to be cured comprises generally the epoxy resin, the hardener and the curing agent. Hardeners are for example hydroxyl and/or carboxyl containing polymers such as carboxyl terminated polyester and/or carboxyl containing acrylate- and/or methacrylate polymers and/or carboxylic acid anhydrides. Useful hardeners are further aliphatic, cycloaliphatic polycarbonic acids. Preferred anhydrides are liquid cycloaliphatic anhydrides with a viscosity at 25°C of 70-80 mPa s. Such a liquid cycloaliphatic anhydride hardener is for example Aradur® HY 1235 (Huntsman Advanced Materials Ltd.). The optional hardener can be used in concentrations within the range of 0.2 to 1.2, equivalents of hardening groups present, e.g. one anhydride group per 1 epoxide equivalent.

The inorganic filler is present in the synthetic polymer composition within the range of 60 % by weight to 80 % by weight, preferably within the range of 60 % by weight to 70 % by weight, and preferably at 65 % by weight, calculated to the total weight of the synthetic polymer composition.

The inorganic filler has an average grain size as known for the use in electrical insulation systems and is generally within the range of 10 micron up to 3 mm and is not critical for the present invention. The mineral filler is preferably selected from conventional filler materials as are generally used as fillers in electrical insulations. Preferably said filler is selected from silica, quartz, known silicates, aluminium oxide, aluminium trihydrate [ATH], titanium oxide or dolomite [CaMg(CO₃)₂], metal nitrides, such as silicon nitride, boron nitride and aluminium nitride or metal carbides, such as silicon carbide. Preferred are silica and quartz with a minimum SiO₂-content of 95-97 % by weight.

As optional additives the composition may comprise further a curing agent (accelerant) for enhancing the polymerization of the epoxy resin with the hardener. Further additives may be selected from wetting/dispersing agents, flexibilizers, plasticizers, antioxidants, light absorbers, silicones, pigments, flame retardants, fibers and other additives generally used in electrical applications. These are known to the expert and not critical for the present invention.

If said thin coating is applied by a plasma enhanced chemical vapor deposition (PECVD) its thickness is within the range of 50 nm to 50 µm; preferably within the range of 100 nm to 30 µm, preferably within the range of 200 nm to 20 µm, preferably within the range of 250 nm to 10 µm, preferably within the range of 300 nm to 5 µm.

Said thin coat is an electrically non-conductive polymeric material and consists essentially of a plasma polymer or an amorphous glass-like coating. The thin coat has a melting point which is distinctly higher than the melting point of the synthetic polymer composition, i.e. the melting point is at least 200°C higher than the melting point or degradation temperature of the synthetic polymer composition.

A polymer coating applied by a plasma enhanced chemical vapor deposition (PECVD) are also named "plasma polymer". Plasma polymers made by PECVD are different from synthetic polymers made by polymerization of a monomeric starting material. When using plasma enhanced chemical vapor deposition (PECVD), the monomeric starting material is heated in a carrier gas to a relatively high temperature, optionally together with a filler component. The plasma yields ionized molecules by working at high temperatures initiated by applying e.g. a strong electrical field or radio frequency (RF). The plasma polymer is formed on the surface of the synthetic polymer composition by directing the material stream ionized in the plasma reactor onto the surface of the synthetic polymer composition to be coated resp. to be modified. Analogous procedures by using plasma technology have been described and are known to the expert.

As a carrier gas preferably oxygen, nitrogen, or a hydrocarbon is used, preferably methane or ethane. As starting materials for producing the thin coat preferably volatile compounds having non-polar groups are used, preferably selected from organosilane compounds, alkoxyorthosilicates, organofluorine compounds, and mixtures thereof. Preferred are compounds selected from hexaalkyldisiloxanes, preferably hexamethyldisiloxane or vinyl-trimethylsilane; tetraalkylorthosilicates, preferably tetraethylorthosilicate; or a mixture of these compounds. These compounds may optionally be mixed with a fine filler material, preferably with fine silica or fine quartz, having a minimum SiO₂-content of 95-97 % by weight, and having preferably an average grain size within the nano size range or very low micron size range (1 µm to 10 µm).

A plasma polymer is composed of numerous different units originating from the ionized plasma particles and does not have a precise chemical composition as compared to a synthetic polymer polymerized by known polymerization techniques. Unexpectedly a surprisingly stable hydrophobic glass-like plasma polymer is obtained on the surface of the synthetic polymer composition, modifying said surface, and wherein said glass-like material also has a high melting point and/or degradation temperature.

If said thin coating is applied by a sol-gel technique with a thickness within the range of 0.5 µm to 2 mm; preferably within the range of 1.0 µm to 1 mm, preferably within the range of 1 µm to 500 µm, preferably within the range of 1 µm to 100 µm.

Coatings made from silane based sol-gel (a densely cross-linked network, obtained after removal of solvent) on synthetic polymer compositions, preferably on cycloaliphatic epoxy compositions, surprisingly improve tracking and erosion resistance of the insulation system made according to the present invention.

Silanes to be employed within the silane based sol-gel to form a thin layer on synthetic polymer compositions according to the present invention preferably are selected from alkoxysilanes and florosilanes. Organo-alkoxysilanes refer to the class of alkoxysilane molecules, having one organic chain and three alkoxy groups linked to the silicon atom. It corresponds to the following formula: [R-Si(OR₁)₃], wherein R is a further (-OR₁)-substituent, or alkyl or a substituted alkyl, preferably (C₁-C₂₂)-alkyl, optionally substituted with an amine, an epoxy, an acrylate, a methacrylate, a phenolic residue or a melamine-residue. R₁ preferably is (C₁₋₄)-alkyl, preferably methyl. Thus, upon hydrolysis and condensation a combination of organic-inorganic network is obtained. The reaction sequence and the special treatment to obtain a thin film resp. coat is known and described in E.P. Plueddmann, Silane Coupling Agents, 2. Ed., 1990, Plenum Press, New York.

Suitable compounds to be used to carry out the present invention which correspond to the formula [R-Si(OR₁)₃] as defined above, are for example hexadecyltrimethoxysilane, 3-glycidoxypropyltrimethoxysilane, 3-glycidoxypropyltriethoxysilane, 3-aminopropyltriethoxysilane, tetraethoxysilane, methacryloxypropyltrimethoxysilane, vinyltrialkoxysilane, where the alkoxy can be an ethoxy or methoxy group.

The reactions of hydrolysis and condensation are strongly dependent on the acid value (pH-value), but under optimum conditions hydrolysis is comparatively quick (some minutes) while the condensation reaction is slower (some hours). Under mildly acidic conditions, neutral alkoxysilanes hydrolyze to form monomeric silanetriols which then condense slowly to polymeric organic siloxanols. During the initial stages of reaction there is a competition between the reactions of hydrolysis and condensation. During hydrolysis, one has to take extra care to avoid crosslinking, as, if it happens, then the mixture will react to a high molecular weight polymerized siloxane and will be unable for forming a coat on the desired surface. Therefore, one has to prepare any silane based sol-gel in two steps. In the first step, hydrolysis of silane solution in a solvent is carried out. Once hydrolyzed, in a subsequent step, this mixture is coated on the substrate, preferably an epoxy substrate, and cross-linked.

The present invention also refers to a method of producing the surface modified electrical insulation system comprising a synthetic polymer composition including at least one filler and optionally further additives, as defined in the present invention, comprising the following steps: (i) providing a hardened or cured synthetic polymer composition including at least one filler and optionally further additives, using known methods; and (ii) applying to the surface of said synthetic polymer composition a thin coating with a thickness within the range of 50 nanometer to 50 µm (as defined herein above), said thin coating being applied by a plasma enhanced chemical vapor deposition (PECVD); and/or applying to the surface of said synthetic polymer composition a thin coating being with a thickness within the range of 0.5 micron to 2 mm (as defined herein above) being applied by a sol-gel technique and (iii) wherein for producing said thin coating an electrically non-conductive monomeric material as defined herein above is used. Preferred uses of the surface modified electrical insulation system as defined in the present invention are in power transmission and distribution applications, such as electrical insulations, especially in the field of impregnating electrical coils and in the production of electrical components such as transformers, embedded poles, bushings, high-voltage insulators for indoor and outdoor use, especially for outdoor insulators associated with high-voltage lines, as long-rod, composite and cap-type insulators, sensors, converters and cable end seals as well as for base insulators in the medium-voltage sector, in the production of insulators associated with outdoor power switches, measuring transducers, lead-throughs, and over-voltage protectors, in switchgear construction.

The following examples illustrate the invention.

### Example 1

Example 1 describes the manufacturing of a glass-like coating with a thickness in the range of 0.3 to 1.2 µm, deposited by plasma enhanced chemical vapor deposition (PECVD) on a substrate of a cycloaliphatic outdoor epoxy insulation. PECVD can be carried out so that the substrate is exposed to not higher than about 100°C.

An oxygen plasma, in an atmosphere of hexamethylendisiloxane (HMDSO) is used. Thereby, the bonds of the HMDSO molecules are broken by the high energy of the plasma and accelerated towards the substrate. When the elements recombine on the substrate surface, a number of chemical reactions take place and oxygen, hydrogen and carbon dioxide are formed and evolve. The coating which forms on the substrate surface is of a dense cross-linked amorphous structure and substantially contains silicon atoms and oxygen atoms in a ratio of about 1:2. It is difficult to determine the precise composition of the coating. The coating therefore is named "plasma polymer" or "SiOₓ-polymer".

### Substrate manufacture

The cycloaliphatic epoxy (CEP) formulation used as the substrate material in this example is given in Table 1. All components, except the catalyst, were pre-heated to 45°C. These were then intensively mixed together at ambient pressure with a propeller mixer. The complete mixture was then degassed in a vacuum oven, with mixing, at 5 mbar, for 20 minutes at 60°C.

The mixture was then molded into 6 mm thick plates using steel moulds pre-heated to 90°C and coated with Huntsman QZ13 mould-release agent. A curing cycle of 2 hours at 90°C, followed by 24 hours at 140°C, was applied to ensure complete curing.

**Table 1**

| Components | phr |
|---|---|
| Huntsman CY184 (Resin) | 100 |
| Huntsman HY1235 (Hardener) | 90 |
| Huntsman DY062 (Catalyst) | 0.54 |
| Huntsman DW9134 (Pigment, TiO₂) | 2.7 |
| Quarzwerke W 12EST (Filler) | 359 |

| | |
|---|---|
| Araldite® CY 184: Cycloaliphatic epoxy resin (Huntsman) Aradur®HY1235: modified cycloaliphatic anhydride (Huntsman) Accelerator DY062: liquid tertiary amine W12 EST: SiO₂ (Quarzwerke GmbH) | |

### PECVD Coating

The SiOₓ coatings were applied to the CEP substrates by plasma enhanced chemical vapor deposition (PECVD). The PECVD equipment used was essentially a vacuum chamber containing a radio frequency (RF) plasma source. The equipment was designed for the coating of flat polymeric film substrates. The dimensions of the tracking erosion test samples were 6 mm x 50 mm x 120 mm. The SiOₓ coating applied had a thickness of 0.3 µm. During the deposition process, the temperature of the epoxy did not exceed 100°C.

Further samples were coated with multiples of 0.3 µm thickness, i.e. 0.6 µm, 0.9 µm and 1.2 µm. The desired coating thickness was achieved by varying the deposition time of the coating. For achieving a thickness of 0.3 µm a deposition time of 60 seconds was used and extended to 120 seconds, 280 seconds and 240 seconds respectively to achieve the greater thickness.

To ensure good adhesion of the SiOₓ coating to the CEP substrate, the surface of the sample was cleaned in an ultrasonic bath, under acetone, before placing in the chamber. In the chamber, the plasma was ignited in the absence of the working gas to energize the sample surface. The parameters for this pre-treatment and the subsequent deposition of the coating are given in Table 2.

**Table 2**

| Chamber evacuation | |
|---|---|
| Base pressure | 3-8 x 10⁻³ mbar |

| Plasma pre-treatment | |
|---|---|
| Power (RF) | 50 W |
| Volume of oxygen (O₂) | 50 sccm |
| Pressure | 0.1 mbar |
| Time | 6 s |

| Deposition | |
|---|---|
| Power (RF) | 212 W |
| Volume of HMDSO | 10 sccm |
| Volume of O₂ | 150 sccm |
| O₂ : HMDSO (mix ratio) | 15:1 |
| Pressure | 0.1 mbar |
| Temperature of CEP substrate | 25°C |
| Time of deposition | 60 s |

### Tracking and erosion resistance (IEC 60587)

The inclined-plane tracking and erosion test (IEC 60587 ed. May 2007) was used to evaluate the tracking resistance and erosion resistance of the coated and uncoated samples. Four test voltage levels (2.5 kVᵣₘₛ, 3.5 kVᵣₘₛ, 4.5 kVᵣₘₛ and 6 kVᵣₘₛ) are specified by the standard, which are the potentials applied between the two electrodes at the bottom and top of the sample during testing. A sodium chloride salt solution, containing a non-ionic wetting agent, and with a defined conductivity, flows over the sample surface from the top to the bottom electrode with a defined flow rate. This arrangement causes arcing on the surface of the sample, concentrated at the bottom electrode. The standard allows two methods of determining a sample failure, referred to as criteria A and B. In this work criteria A was used, defined as the leakage current across a sample exceeding 60 mAᵣₘₛ for a duration of 2 seconds. A sample is determined to have passed if it survives 6 hours of testing without failure. For a material to pass the test, all 5 samples should survive for 6 hours.

The tracking and erosion resistance of coated and uncoated CEP samples was evaluated by the inclined plane method. The CEP samples were tested with and without abrading. Results are given in Table 3.

**Table 3 (Inclined plane tracking and erosion test results according to IEC 60587)**

| | 3.5 kVᵣₘₛ | 4.5 kVᵣₘₛ | 6 kVᵣₘₛ |
|---|---|---|---|
| CEP (abraded) | Passed | Failed (all 5 samples failed within 30 minutes) | |
| CEP (not abraded) | | Failed (4 samples passed, 1 sample failed after 40 minutes) | |
| CEP with 0.3 µm SiO₂ coating (not abraded) | | Passed | Passed |

Where a material is classifieded as "failed" for a particular test voltage, 1 or more of the 5 samples had failed the test. Where it is classed as passed, none of the 5 samples failed.

The samples with coating thickness of 0.6 µm, 0.9 µm and 1.2 µm were tested together at 6 kVᵣₘₛ. All samples survived 6 hours and no difference was observed between their performance and those of the 0.3 µm thick coatings. The results demonstrate that tracking and erosion measurements show an distinct improvement in tracking and erosion resistance of the PECVD coated samples, according the IEC inclined plane test.

### Example 2

Example 2 describes the manufacturing of a glass-like coating with a thickness in the range of 0.5 µm to 2 mm, deposited by the hybrid sol-gel coating method on a substrate of a cycloaliphatic outdoor epoxy insulation. The substrate manufacture was carried out as described in Example 1, with the components as given in Table 1.

Silanes used in the hybrid sol-gel coating method were functionalized-alkoxysilanes, i.e. tetraethoxysilane (TEOS), 3-glycidyloxypropyltrimethoxysilane (GPTMS, an epoxized trimethoxysilane) and hexadecyltrimethoxysilane (HDMS) having a long hydrophobic chain substituent.

Coating formulations and process conditions for silane based sol-gel coatings are shown in Table 4. These chemicals were mixed together at room temperature and kept separately to avoid any crosslinking between them. Coatings were carried out at room temperature.

**Table 4**

| | Molar Ratios | | | | | | | |
|---|---|---|---|---|---|---|---|---|
| Coating Formulation | TEOS | GPTMS | HDMS | Water | Ethanol | Aerosil | HC1 | Process conditions |
| A | 2 | 1 | -.- | 2 | 27 | -.- | 0.07 | (A) |
| B | 1 | -.- | -.- | 2 | 27 | -.- | 0.07 | (B) |
| C | -.- | 1 | -.- | 2 | 27 | -.- | 0.07 | (C) |
| D | -.- | -.- | 1 | 2 | 27 | -.- | 0.07 | (D) |
| E | -.- | -.- | 1 | -.- | 27 | 5% b.w. of HDMS | 0.07 | (E) |

### Process conditions:

(A) First hydrolyse TEOS for 6 hours and then slowly add GPTMS and stir for 18 hours at 25°C
(B) Hydrolysis for 10 hours at 25°C
(C) Hydrolysis for 10 hours at 25°C
(D) White precipitates were obtained after 1 minute of hydrolysis, therefore this coating formulation was not used
(E) Mixed for 4 hours at 25°C

### Tracking and erosion resistance (IEC 60587)

For the sol-gel coatings of formulation A or B+C (in the ratio of 70:30 vol. %) or B+C+E (in the ratio of 60:30:10 vol. %) on CEP substrates and curing for 2 hrs. at 100°C, according to this Example 2, tracking and erosion resistance of CEP samples was found to be improved according to IEC 60587. Results obtained were analogous to Example 1, Table 3.

## Claims

1. Surface modified electrical insulation system comprising a hardened or cured synthetic polymer composition including at least one filler and optionally further additives, **characterized in that** the surface of said synthetic polymer composition is modified by being coated with a thin coating;
- said thin coating being applied by a plasma enhanced chemical vapor deposition (PECVD) with a thickness within the range of 50 nanometer to 50 µm; and/or
- said thin coating being applied by a by a sol-gel technique with a thickness within the range of 0.5 micron to 1 mm; and wherein
- said thin coat being an electrically non-conductive polymeric material having a melting point which is distinctly higher than the melting point or degradation temperature of the synthetic filler containing polymer composition.

2. Electrical insulation system according to claim 1, **characterized in that** both types of thin coatings have been applied, either one on top of the other in any desired sequence.

3. Electrical insulation system according to claim 1 or 2, **characterized in that** said synthetic polymer is selected from polymers known in the art of being used in electrical insulator composition, preferably from polyesters, preferably poly(methylmethacrylate), or poly(alkylacrylonitrile); or from duroplastic polymers preferably polyurethanes or epoxy resin compositions.

4. Electrical insulation system according to claim 3, **characterized in that** said synthetic polymer is an epoxy resin composition, preferably based on a cycloaliphatic epoxy resin compound.

5. Electrical insulation system according to any one of the claims 1-4, **characterized in that** the inorganic filler is present in the synthetic polymer composition within the range of 60 % by weight to 80 % by weight, preferably within the range of 60 % by weight to 70 % by weight, and preferably at 65 % by weight, calculated to the total weight of the synthetic polymer composition.

6. Electrical insulation system according to any one of the claims 1-5, **characterized in that** the synthetic polymer composition further contains additives selected from wetting/dispersing agents, flexibilizers, plasticizers, antioxidants, light absorbers, silicones, pigments, flame retardants, fibers and other additives generally used in electrical applications.

7. Electrical insulation system according to any one of the claims 1-6, **characterized in that** said thin coating is applied by a plasma enhanced chemical vapor deposition (PECVD) with a thickness within the range of 50 nm to 50 µm; preferably within the range of 100 nm to 30 µm, preferably within the range of 200 nm to 20 µm, preferably within the range of 250 nm to 10 µm, preferably within the range of 300 nm to 5 µm.

8. Electrical insulation system according to claim 7, **characterized in that** the starting materials for producing the thin coat is a volatile compound having non-polar groups, and is preferably selected from organosilane compounds, alkoxyorthosilicates, organofluorine compounds, and mixtures thereof.

9. Electrical insulation system according to claim 8, **characterized in that** said starting material is selected from hexaalkyldisiloxanes, preferably hexamethyldisiloxane or vinyl-trimethylsilane; tetraalkylorthosilicates, preferably tetraethylorthosilicate; or a mixture of these compounds.

10. Electrical insulation system according to claim 9, **characterized in that** said starting materials are mixed with a fine filler material, preferably with fine silica or fine quartz, having a minimum SiO₂-content of 95-97 % by weight, and having preferably an average grain size within the nano size range or very low micron size range (1 µm to 10 µm).

11. Electrical insulation system according to any one of the claims 1-6, **characterized in that** said thin coating is applied by a sol-gel technique with a thickness within the range of 0.5 µm to 2 mm; preferably within the range of 1.0 µm to 1 mm, preferably within the range of 1 µm to 500 µm, preferably within the range of 1 µm to 100 µm.

12. Electrical insulation system according to claim 11, **characterized in that** said coating is made from silane based sol-gel wherein the starting silanes are selected from alkoxysilanes and florosilanes.

13. Electrical insulation system according to claim 12, **characterized in that** the alkoxysilanes and florosilanes are selected from compounds of formula: [R-Si(OR₁)₃], wherein R is a further (-OR₁)-substituent, or alkyl or a substituted alkyl, preferably (C₁-C₂₂)-alkyl, optionally substituted with an amine, an epoxy, an acrylate, a methacrylate, a phenolic residue or a melamine-residue, and R₁ is (C₁₋₄)-alkyl, preferably methyl.

14. Electrical insulation system according to claim 13, **characterized in that** the alkoxysilanes and florosilanes are selected from the group comprising hexadecyltrimethoxysilane, 3-glycidoxypropyltrimethoxysilane, 3-glycidoxypropyltriethoxysilane, 3-aminopropyltriethoxysilane, tetraethoxysilane, methacryloxypropyltrimethoxysilane, vinyltrialkoxysilane, where the alkoxy can be an ethoxy or methoxy group.

15. Method of producing the surface modified electrical insulation system according to any one of the claims 1-14, comprising the following steps: (i) providing a hardened or cured synthetic polymer composition including at least one filler and optionally further additives, using known methods; and (ii) applying to the surface of said synthetic polymer composition a thin coating with a thickness within the range of 50 nanometer to 50 µm, said thin coating being applied by a plasma enhanced chemical vapor deposition (PECVD); and/or applying to the surface of said synthetic polymer composition a thin coating being with a thickness within the range of 0.5 micron to 2 mm being applied by a sol-gel technique and (iii) wherein for producing said thin coating an electrically non-conductive monomeric material is used.

16. Method according to claim 15, wherein both types of thin coatings are applied, either one on top of the other in any desired sequence.

17. The use of the surface modified electrical insulation system as defined in any of the claims 1-14, in power transmission and distribution applications, preferably electrical insulations, especially in the field of impregnating electrical coils and in the production of electrical components such as transformers, embedded poles, bushings, high-voltage insulators for indoor and outdoor use, especially for outdoor insulators associated with high-voltage lines, as long-rod, composite and cap-type insulators, sensors, converters and cable end seals as well as for base insulators in the medium-voltage sector, in the production of insulators associated with outdoor power switches, measuring transducers, lead-throughs, and over-voltage protectors, in switchgear construction.

18. Electrical articles comprising a surface modified electrical insulation system according to any one of the claims 1-14.

## Patentansprüche

1. Oberflächenmodifiziertes elektrisches Isolationssystem, umfassend eine gehärtete Synthesepolymerzusammensetzung, die mindestens einen Füllstoff und gegebenenfalls weitere Additive enthält, **dadurch gekennzeichnet, daß** die Oberfläche der Synthesepolymerzusammensetzung **dadurch** modifiziert ist, daß sie mit einem dünnen Überzug überzogen ist;
- wobei der dünne Überzug durch plasmagestützte chemische Gasphasenabscheidung (PECVD) mit einer Dicke im Bereich von 50 Nanometer bis 50 µm aufgebracht wird; und/oder
- wobei der dünne Überzug nach einer Sol-Gel-Technik mit einer Dicke im Bereich von 0,5 Mikron bis 1 mm aufgebracht wird; und wobei
- es sich bei dem dünnen Überzug um ein elektrisch nichtleitendes polymeres Material mit einem Schmelzpunkt, der deutlich über dem Schmelzpunkt bzw. der Abbautemperatur der füllstoffhaltigen Synthesepolymerzusammensetzung liegt, handelt.

2. Elektrisches Isolationssystem nach Anspruch 1, **dadurch gekennzeichnet, daß** beide Arten von dünnen Überzügen in einer beliebigen gewünschten Reihenfolge übereinander aufgebracht worden sind.

3. Elektrisches Isolationssystem nach Anspruch 1 oder 2, **dadurch gekennzeichnet, daß** das Synthesepolymer unter Polymeren, die in der Technik für die Verwendung in elektrisch isolierenden Zusammensetzungen bekannt sind, vorzugsweise unter Polyestern, vorzugsweise Poly(methylmethacrylat), oder Poly(alkylacrylnitril), oder unter duroplastischen Polymeren, vorzugsweise Polyurethanen oder Epoxidharzzusammensetzungen, ausgewählt ist.

4. Elektrisches Isolationssystem nach Anspruch 3, **dadurch gekennzeichnet, daß** es sich bei dem Synthesepolymer um eine Epoxidharzzusammensetzung handelt, die vorzugsweise auf einer cycloaliphatischen Epoxidharzverbindung basiert.

5. Elektrisches Isolationssystem nach einem der Ansprüche 1-4, **dadurch gekennzeichnet, daß** der anorganische Füllstoff in der Synthesepolymerzusammensetzung im Bereich von 60 Gew.-% bis 80 Gew.-%, vorzugsweise im Bereich von 60 Gew.-% bis 70 Ges.-% und vorzugsweise in einer Menge von 65 Gew.-%, berechnet auf das Gesamtgewicht der synthetischen Polymerzusammensetzung, vorliegt.

6. Elektrisches Isolationssystem nach einem der Ansprüche 1-5, **dadurch gekennzeichnet, daß** die Synthesepolymerzusammensetzung ferner unter Netz/Dispergiermitteln, Flexibilisierungsmitteln, Weichmachern, Antioxidantien, Lichtabsorbern, Silikonen, Pigmenten, Flammschutzmitteln, Fasern und anderen Additiven, die im allgemeinen bei elektrischen Anwendungen verwendet werden, ausgewählte Additive enthält.

7. Elektrisches Isolationssystem nach einem der Ansprüche 1-6, **dadurch gekennzeichnet, daß** der dünne Überzug durch plasmagestützte chemische Gasphasenabscheidung (PECVD) mit einer Dicke im Bereich von 50 Nanometer bis 50 µm, vorzugsweise im Bereich von 100 nm bis 30 µm, vorzugsweise im Bereich von 200 nm bis 20 µm, vorzugsweise im Bereich von 250 nm bis 10 µm, vorzugsweise im Bereich von 300 nm bis 5 µm, aufgebracht wird.

8. Elektrisches Isolationssystem nach Anspruch 7, **dadurch gekennzeichnet, daß** der Ausgangsstoff zur Herstellung des dünnen Überzugs eine flüchtige Verbindung mit unpolaren Gruppen ist und vorzugsweise unter Organosilanverbindungen, Alkoxyorthosilikaten, Organofluorverbindungen und Mischungen davon ausgewählt ist.

9. Elektrisches Isolationssystem nach Anspruch 8, **dadurch gekennzeichnet, daß** der Ausgangsstoff unter Hexaalkyldisiloxanen, vorzugsweise Hexamethyldisiloxan oder Vinyltrimethylsilan, Tetraalkylorthosilikaten, vorzugsweise Tetraethylorthosilikat, oder einer Mischung dieser Verbindungen ausgewählt ist.

10. Elektrisches Isolationssystem nach Anspruch 9, **dadurch gekennzeichnet, daß** die Ausgangsstoffe mit einem feinen Füllstoffmaterial, vorzugsweise mit feinem Siliciumdioxid oder feinem Quarz, mit einem minimalen SiO₂-Gehalt von 95-97 Gew.-% und vorzugsweise mit einer Korngröße im Nanobereich oder sehr kleinen Mikronbereich (1 µm bis 10 µm) gemischt werden.

11. Elektrisches Isolationssystem nach einem der Ansprüche 1 bis 6, **dadurch gekennzeichnet, daß** der dünne Überzug nach einer Sol-Gel-Technik mit einer Dicke im Bereich von 0,5 µm bis 2 mm, vorzugsweise im Bereich von 1,0 µm bis 1 mm, vorzugsweise im Bereich von 1 µm bis 500 µm, vorzugsweise im Bereich von 1 µm bis 100 µm, aufgebracht wird.

12. Elektrisches Isolationssystem nach Anspruch 11, **dadurch gekennzeichnet, daß** der Überzug aus einem auf Silan basierenden Sol-Gel besteht, wobei die Ausgangssilane unter Alkoxysilanen und Fluorsilanen ausgewählt sind.

13. Elektrisches Isolationssystem nach Anspruch 12, **dadurch gekennzeichnet, daß** die Alkoxysilane und Fluorsilane unter Verbindungen der Formel: [R-Si(OR₁)₃], worin R für einen weiteren (-OR₁)-Substituenten oder Alkyl oder substituiertes Alkyl, vorzugsweise (C₁-C₂₂) -Alkyl, das gegebenenfalls durch ein Amin, ein Epoxid, ein Acrylat, ein Methacrylat, einen Phenolrest oder einen Melaminrest substituiert ist, steht und R₁ für (C₁₋₄)-Alkyl, vorzugsweise Methyl, steht, ausgewählt sind.

14. Elektrisches Isolationssystem nach Anspruch 13, **dadurch gekennzeichnet, daß** die Alkoxysilane und Fluorsilane aus der Gruppe umfassend Hexadecyltrimethoxysilan, 3-Glycidoxypropyltrimethoxysilan, 3-Glycidoxypropyltriethoxysilan, 3-Aminopropyltriethoxysilan, Tetraethoxysilan, Methacryloxypropyltrimethoxysilan, Vinyltrialkoxysilan, wobei es sich bei dem Alkoxy um eine Ethoxy- oder Methoxygruppe handeln kann, ausgewählt sind.

15. Verfahren zur Herstellung des oberflächenmodifizierten elektrischen Isolationssystems nach einem der Ansprüche 1-14, bei dem man: (i) unter Verwendung bekannter Verfahren eine gehärtete Synthesepolymerzusammensetzung, die mindestens einen Füllstoff und gegebenenfalls weitere Additive enthält, bereitstellt und (ii) auf die Oberfläche der Synthesepolymerzusammensetzung einen dünnen Überzug mit einer Dicke im Bereich von 50 Nanometer bis 50 µm aufbringt, wobei der dünne Überzug durch plasmagestützte chemische Gasphasenabscheidung (PECVD) aufgebracht wird; und/oder auf die Oberfläche der Synthesepolymerzusammensetzung einen dünnen Überzug mit einer Dicke im Bereich von 0,5 Mikron bis 2 mm aufbringt, welcher nach einer Sol-Gel-Technik aufgebracht wird, und (iii) zur Herstellung des dünnen Überzugs ein elektrisch nichtleitendes monomeres Material verwendet.

16. Verfahren nach Anspruch 15, bei dem man beide Arten von dünnen Überzügen in einer beliebigen gewünschten Reihenfolge übereinander aufbringt.

17. Verwendung des oberflächenmodifizierten elektrischen Isolationssystems gemäß einem der Ansprüche 1-14 in Energieübertragungs- und -verteilungsanwendungen, vorzugsweise elektrischen Isolationen, insbesondere auf dem Gebiet der Imprägnierung von elektrischen Spulen und bei der Herstellung von elektrischen Bauteilen wie Transformatoren, eingebetteten Polen, Durchführungen, Hochspannungsisolatoren für den Innen- und Außeneinsatz, insbesondere für Außenisolatoren, die mit Hochspannungsleitungen assoziiert sind, wie Langstab-, Verbund- und Kappenisolatoren, Sensoren, Konvertern und Kabelenddichtungen, sowie für Stützisolatoren im Mittelspannungsbereich, bei der Herstellung von Isolatoren, die mit Freiluftleistungsschaltern assoziiert sind, Meßwandlern, Durchgriffen und Ableitern, im Schaltanlagenbau.

18. Elektroartikel, umfassend ein oberflächenmodifiziertes elektrisches Isolationssystem nach einem der Ansprüche 1-14.

## Revendications

1. Système d'isolation électrique modifié en surface comprenant une composition de polymère synthétique durcie ou réticulée renfermant au moins une charge et éventuellement d'autres additifs, **caractérisé en ce que** la surface de ladite composition de polymère synthétique est modifiée en étant revêtue d'un revêtement mince ;
l edit revêtement mince étant appliqué par dépôt chimique en phase vapeur assisté par plasma (PECVD) avec une épaisseur dans la fourchette de 50 nanomètres à 50 µm ; et/ou
l edit revêtement mince étant appliqué par une technique sol-gel avec une épaisseur dans la fourchette de 0,5 micron à 1 mm ; et
l adite couche mince étant un matériau polymère non conducteur de l'électricité ayant un point de fusion qui est nettement plus élevé que le point de fusion ou la température de décomposition de la composition de polymère contenant une charge synthétique.

2. Système d'isolation électrique selon la revendication 1, **caractérisé en ce que** les deux types de revêtements minces ont été appliqués ou bien l'un sur l'autre, ou bien dans un ordre quelconque souhaité.

3. Système d'isolation électrique selon la revendication 1 ou 2, **caractérisé en ce que** ledit polymère synthétique est choisi parmi les polymères connus dans la technique pour être utilisés dans une composition d'isolant électrique, de préférence parmi les polyesters, de préférence le poly(méthacrylate de méthyle) ou le poly(alkylacrylonitrile) ; ou parmi les polymères duroplastiques, de préférence les polyuréthanes ou les compositions de résine époxy.

4. Système d'isolation électrique selon la revendication 3, **caractérisé en ce que** ledit polymère synthétique est une composition de résine époxy, de préférence à base de composé résine époxy cycloaliphatique.

5. Système d'isolation électrique selon l'une quelconque des revendications 1-4, **caractérisé en ce que** la charge minérale est présente dans la composition de polymère synthétique dans la fourchette de 60 % en poids à 80 % en poids, de préférence dans la fourchette de 60 % en poids à 70 % en poids, et de préférence à raison de 65 % en poids, le calcul étant rapporté au poids total de la composition de polymère synthétique.

6. Système d'isolation électrique selon l'une quelconque des revendications 1-5, **caractérisé en ce que** la composition de polymère synthétique contient en outre des additifs choisis parmi des agents mouillants/dispersants, des assouplissants, des plastifiants, des antioxydants, des absorbeurs de lumière, des silicones, des pigments, des ignifugeants, des fibres et d'autres additifs généralement utilisés dans les applications électriques.

7. Système d'isolation électrique selon l'une quelconque des revendications 1-6, **caractérisé en ce que** ledit revêtement mince est appliqué par dépôt chimique en phase vapeur assisté par plasma (PECVD) avec une épaisseur dans la fourchette de 50 nm à 50 µm ; de préférence dans la fourchette de 100 nm à 30 µm, de préférence dans la fourchette de 200 nm à 20 µm, de préférence dans la fourchette de 250 nm à 10 µm, de préférence dans la fourchette de 300 nm à 5 µm.

8. Système d'isolation électrique selon la revendication 7, **caractérisé en ce que** la substance de départ permettant de produire la couche mince est un composé volatil possédant des groupes non polaires, et est de préférence choisie parmi les composés organosilane, les alcoxy-ortho-silicates, les composés organofluorés, et leurs mélanges.

9. Système d'isolation électrique selon la revendication 8, **caractérisé en ce que** ladite substance de départ est choisie parmi les hexaalkyldisiloxanes, de préférence l'hexaméthyldisiloxane ou le vinyltriméthyl-silane ; les tétraalkyl-ortho-silicates, de préférence le tétraéthyl-ortho-silicate ; ou un mélange de ces composés.

10. Système d'isolation électrique selon la revendication 9, **caractérisé en ce que** lesdites substances de départ sont mélangées avec une fine matière de charge, de préférence avec de la silice fine ou du quartz fin, ayant une teneur minimale en SiO₂ de 95-97 % en poids, et ayant de préférence une granulométrie moyenne dans le domaine nanométrique ou dans le bas du domaine micrométrique (1 µm à 10 µm).

11. Système d'isolation électrique selon l'une quelconque des revendications 1-6, **caractérisé en ce que** ledit revêtement mince est appliqué par une technique sol-gel avec une épaisseur dans la fourchette de 0,5 µm à 2 mm ; de préférence dans la fourchette de 1,0 µm à 1 mm, de préférence dans la fourchette de 1 µm à 500 µm, de préférence dans la fourchette de 1 µm à 100 µm.

12. Système d'isolation électrique selon la revendication 11, **caractérisé en ce que** ledit revêtement est fait de sol-gel à base de silane dans lequel les silanes de départ sont choisis parmi les alcoxysilanes et les fluorosilanes.

13. Système d'isolation électrique selon la revendication 12, **caractérisé en ce que** les alcoxysilanes et les fluorosilanes sont choisis parmi les composés de formule : [R-Si(OR₁)₃], dans laquelle R est un autre substituant (-OR₁), ou un groupe alkyle ou un alkyle substitué, de préférence alkyle en C₁-C₂₂, éventuellement substitué par un groupe amine, un groupe époxy, un groupe acrylate, un groupe méthacrylate, un résidu phénolique ou un résidu mélamine, et R₁ représente un groupe alkyle en C₁-C₄, de préférence méthyle.

14. Système d'isolation électrique selon la revendication 13, **caractérisé en ce que** les alcoxysilanes et les fluorosilanes sont choisis dans le groupe comprenant l'hexadécyltriméthoxysilane, le 3-glycidoxypropyltriméthoxysilane, le 3-glycidoxypropyltriéthoxysilane, le 3-aminopropyltriéthoxysilane, le tétraéthoxysilane, le méthacryloxypropyltriméthoxysilane, le vinyltrialcoxy-silane, le groupe alcoxy pouvant représenter un groupe éthoxy ou méthoxy.

15. Procédé de production du système d'isolation électrique modifié en surface selon l'une quelconque des revendications 1-14, comprenant les étapes suivantes consistant à : (i) se procurer une composition de polymère synthétique durcie ou réticulée renfermant au moins une charge et éventuellement d'autres additifs, en faisant appel à des procédés connus ; et (ii) appliquer sur la surface de ladite composition de polymère synthétique un revêtement mince ayant une épaisseur dans la fourchette de 50 nanomètre à 50 µm, ledit revêtement mince étant appliqué par dépôt chimique en phase vapeur assisté par plasma (PECVD) ; et/ou appliquer sur la surface de ladite composition de polymère synthétique un revêtement mince ayant une épaisseur dans la fourchette de 0,5 micron à 2 mm au moyen d'une technique sol-gel et (iii) dans lequel, pour produire ledit revêtement mince, on utilise une substance monomère non conductrice de l'électricité.

16. Procédé selon la revendication 15, dans lequel les deux types de revêtements minces sont appliqués ou bien l'un au dessus de l'autre, ou bien dans un ordre quelconque souhaité.

17. Utilisation du système d'isolation électrique modifié en surface tel que défini dans l'une quelconque des revendications 1-14, dans des applications de transmission et distribution de puissance, de préférence des isolations électriques, notamment dans le domaine de l'imprégnation des solénoïdes et dans la production de composants électriques tels que les transformateurs, les pôles encastrés, les isolateurs de traversée, les isolateurs haute tension d'intérieur et d'extérieur, notamment pour les isolateurs d'extérieur associés aux lignes à haute tension, comme les isolateurs à tige longue, composites et à capot, les détecteurs, les convertisseurs et les joints d'extrémités des câbles, ainsi que pour les isolateurs de base dans le secteur de la moyenne tension, dans la production d'isolateurs associés aux interrupteurs de puissance d'extérieur, aux transducteurs de mesure, aux trous de connexion, et les dispositifs de protection contre les surtensions, dans la construction des appareils de connexion.

18. Articles électriques comprenant un système d'isolation électrique modifié en surface selon l'une quelconque des revendications 1-14.
